# EUROPÄISCHE PATENTSCHRIFT

(11) **EP 1 719 184 B1**
(45) Veröffentlichungstag und Bekanntmachung des Hinweises auf die Patenterteilung: **29.08.2018**
(21) Anmeldenummer: 05715613.5
(22) Anmeldetag: 28.02.2005
(51) Int. Cl.: H01L 29/78, H01L 29/10, H01L 21/336, H01L 21/266

(54) **HOCHVOLT-PMOS-TRANSISTOR**
HIGH VOLTAGE PMOS TRANSISTOR
TRANSISTOR PMOS HAUTE TENSION

(30) Priorität: 27.02.2004 DE 102004009521
(43) Veröffentlichungstag der Anmeldung: 08.11.2006
(73) Patentinhaber: ams AG, 8141 Premstätten (AT)
(72) Erfinder: KNAIPP, Martin, A-8141 Premstätten (AT)
(74) Vertreter: Epping - Hermann - Fischer
(86) Internationale Anmeldenummer: PCT/EP2005/002112
(87) Internationale Veröffentlichungsnummer: WO 2005/083794

(56) Entgegenhaltungen:
- EP-A- 0 524 030
- EP-A- 0 973 205
- WO-A-03/092078
- STENGL R ET AL: "VARIATION OF LATERAL DOPING - A NEW CONCEPT TO AVOID HIGH VOLTAGE BREAKDOWN OF PLANAR JUNCTIONS" INTERNATIONAL ELECTRON DEVICES MEETING, WASHINGTON, DC, USA, 1. Dezember 1985 (1985-12-01), Seiten 154-157, XP002013050 IEEE, NEW YORK, NY, USA
- BASSIN C ET AL: "HIGH-VOLTAGE DEVICES FOR 0.5-MUM STANDARD CMOS TECHNOLOGY" IEEE ELECTRON DEVICE LETTERS, Bd. 21, Nr. 1, Januar 2000 (2000-01), Seiten 40-42, XP000890465 IEEE, NEW YORK, NY, USA ISSN: 0741-3106
- KINOSHITA K ET AL: "A NEW ADAPTIVE RESURF CONCEPT FOR 20 V LDMOS WITHOUT BREAKDOWN VOLTAGE DEGRADATION AT HIGH CURRENT" PROCEEDINGS OF THE 10TH INTERNATIONAL SYMPOSIUM ON POWER SEMICONDUCTOR DEVICES & ICS (ISPSD '98), KYOTO, JP, 3. Juni 1998 (1998-06-03), Seiten 65-68, XP000801037 IEEE, NEW YORK, NY, USA ISBN: 0-7803-4752-8

## Beschreibung

Die Erfindung betrifft einen Hochvolt-PMOS-Transistor mit einer isolierten Gate-Elektrode, einem p-leitenden Sourcegebiet in einer n-leitenden Wanne und einem p-leitenden Draingebiet in einer p-leitenden Wanne, die in der n-Wanne angeordnet ist.

Die an sich bekannte Herstellung von Hochvolttransistoren in integrierten Schaltungen führt regelmäßig zu optimierten Transistoren für den gewünschten Spannungsbereich. Dieser kann sich von mehr als 10 Volt bis zu 150 Volt und darüber hinaus erstrecken. Typische Anwendung ist die Automobiltechnik, in der neben logischen Schaltungselementen auch Schalter für die Batteriespannungsebenen und für die Beherrschung von Störpulsen (bursts) vorgesehen werden müssen. Diese Hochvolttransistoren sind grundsätzlich mit Prozessen herstellbar, wie sie für CMOS-Schaltungen mit Einsatzbereichen von 3,3 Volt bzw. 5 Volt verwendet werden. Allerdings ist diese Herstellung aufwendig und teuer, weil eine Mehrzahl zusätzlicher Masken und Prozessschritte notwendig sind und/oder ein großer Platzbedarf des Hochvolttransistors resultiert.

Vertikale Hochvolttransistoren werden gewöhnlich in einer Epitaxieschicht erzeugt, deren Dicke und Konzentration für den gewünschten Spannungsbereich optimiert werden muss. Die Schichtdicken können schnell bei 10 µm oder darüber liegen, was nur mit einer aufwendigen Epitaxieabscheidung realisierbar ist. Die notwendige vergrabene Schicht (buried layer), ihre Dotierung und Kontaktierung durch die Epitaxieschicht (sinker) erfordern etliche speziell für den Hochvolttransistor notwendige Prozessschritte. Um die Transistorfläche, d.h. seine laterale Ausdehnung zu optimieren, muss die Dicke der Epitaxieschicht an die gewünschte Spannungsebene angepasst werden.

Der Versuch, Hochvolttransistoren als laterale Transistoren in Verbindung mit einem Niedervoltprozess für Logiktransistoren herzustellen, führt zu anderen Schwierigkeiten. So müssen die elektrischen Feldstärken so beherrscht werden, dass an den Stellen höchster Feldstärkekonzentration kein Durchbruch auftritt, der zu Fehlfunktionen oder zur Zerstörung des integrierten Schaltkreises führen kann. In der Regel führt diese Anforderung zu einem großen Platzbedarf für die Hochvolttransistoren und damit zu hohen Herstellkosten.

Die EP 0 973 205 A2 beschreibt einen Hochspannungs-MOS-Transistor mit einer Drain-Erweiterung, bei der die einbettende n-Wanne unterhalb der Drain-Erweiterung eine geringere Tiefe aufweist als unterhalb der vorgesehenen Drain. Die Tiefe der p-leitenden Wanne ist im Bereich der Drain-Erweiterung größer als unterhalb der vorgesehenen Drain. Die Stellen geringster Tiefe der n-Wanne und größter Tiefe der p-Wanne sind gegeneinander versetzt.

Dokument R. Stengl und U. Gösele: "Variation of Lateral Doping - A New Concept to Avoid High Voltage Breakdown of Planar Junctions", International Electron Devices Meeting, Technical Digest, 1. bis 4. Dezember 1985, Seiten 154 bis 157 (XP002013050) beschreibt eine Maskierung zur Herstellung einer p-leitenden Wanne, bei der zwischen dem Zentralbereich und dem Randbereich der zu erzeugenden Wanne abschnittsweise zusätzliche Abdeckungen vorgesehen sind.

Aus der US 6,455,893 B1 ist ein lateraler Hochvolttransistor bekannt, der einen geringeren Platz benötigt, weil die an der hochdotierten Drain auftretende elektrische Feldstärke mittels einer geringer dotierten Drain-Erweiterung und einer Feldplatte reduziert wird. Der beschriebene Transistor ist auch für CMOS-Prozesse mit weniger als 1 µm Strukturbreite einsetzbar. Jedoch führt die Schrift an, dass die Spannungsfestigkeit des Transistors eingeschränkt ist, weil das retrograde Implantationsprofil in den Randbereichen der Drain-Erweiterung zu einem wenig geeigneten Dotierungsmuster führt.

Es ist Aufgabe der Erfindung, einen verbesserten lateralen Hochvolt-PMOS-Transistor sowie ein Verfahren für die Herstellung der Wannen anzugeben.

Die Erfindung löst diese Aufgabe mit den Merkmalen der unabhängigen Patentansprüche. Ausgestaltungen der Erfindung sind in weiteren Ansprüchen gekennzeichnet.

Ein Hochvolt-PMOS-Transistor nach der Erfindung hat den Vorteil, dass er mit einem an sich üblichen Niedervoltprozess, der an sich nicht für den gewünschten Hochvolt-Bereich vorgesehen ist, mit nur geringem zusätzlichen Aufwand herstellbar ist. Dadurch wird gewährleistet, dass die Kombination von Hochvolttransistoren und Niedervolttransistoren zwar zu verbesserten Hochvolteigenschaften führt, jedoch die Niedervolteigenschaften der entsprechenden Transistoren nicht beeinträchtigt werden. Insbesondere hat deshalb der erfindungsgemäße Hochvolttransistor den Vorteil, dass eine höhere Betriebsspannung zulässig ist.

Die Erfindung hat den weiteren Vorteil, dass bei der vorgesehenen hohen Spannung kein Durchbruch von der p-Wanne zum Substrat erfolgen kann.

Darüber hinaus hat die Erfindung den weiteren Vorteil, dass die kritische elektrische Feldstärke in der p-Wanne unterhalb des Drains reduziert ist, wenn der Drainkontakt mit stark negativer Spannung gegenüber Source vorgespannt ist.

In einer Ausgestaltung der Erfindung liegt der Vorteil, dass die elektrische Feldstärke an der Oberfläche der Struktur reduziert ist, was als RESURF-Effekt bekannt ist (RESURF entspricht "REduced SURface Field").

Hierzu ist oberhalb der als Driftstrecke dienenden p-Wanne eine Feldplatte vorgesehen, die auf dem Feldoxid angeordnet ist.

Eine weitere Ausgestaltung der Erfindung sieht vor, dass die elektrische Feldstärke weiterhin gesteuert wird mit Hilfe einer Metallisierungsschicht der ersten Metallisierungsebene, die mit der Feldplatte auf dem Feldoxid mit Hilfe einer Durchkontaktierung elektrisch verbunden ist und sich lateral in Richtung auf das Draingebiet über dem Feldoxid erstreckt.

Die Erfindung hat den weiteren Vorteil, dass sich mit der Maske bzw. Maskierung die Ladungsträgerkonzentration in der n-Wanne bzw. der p-Wanne im kritischen Bereich unterhalb des Draingebiets kontrollieren lassen.

Schließlich hat die Erfindung den Vorteil, dass sie ein Verfahren zur Herstellung der n-Wannenbereiche bzw. p-Wannenbereiche am Transistorkopf, d.h. an den Randbereichen unterhalb des Draingebiets ermöglicht, die für die vorgesehene Spannung optimiert sind.

Die Erfindung wird nachfolgend anhand von Ausführungsbeispielen in den Figuren der Zeichnung näher erläutert. Die Figuren dienen allein der Veranschaulichung der Erfindung und sind daher nur schematisch und nicht maßstabsgetreu ausgeführt. Gleiche Elemente oder gleich wirkende Elemente sind mit gleichen Bezugszeichen versehen. Es zeigen:
- Figur 1: einen schematischen Querschnitt durch einen Hoch-volt-PMOS-Transistor gemäß der Erfindung,
- Figur 2: einen Ausschnitt aus der Maske zur Herstellung der n-Wanne, insbesondere am Transistorkopf,
- Figur 3: einen Ausschnitt aus der Maske zur Herstellung der p-Wanne und
- Figur 4: einen Hochvolt-PMOS-Transistor in Anlehnung an den Stand der Technik.

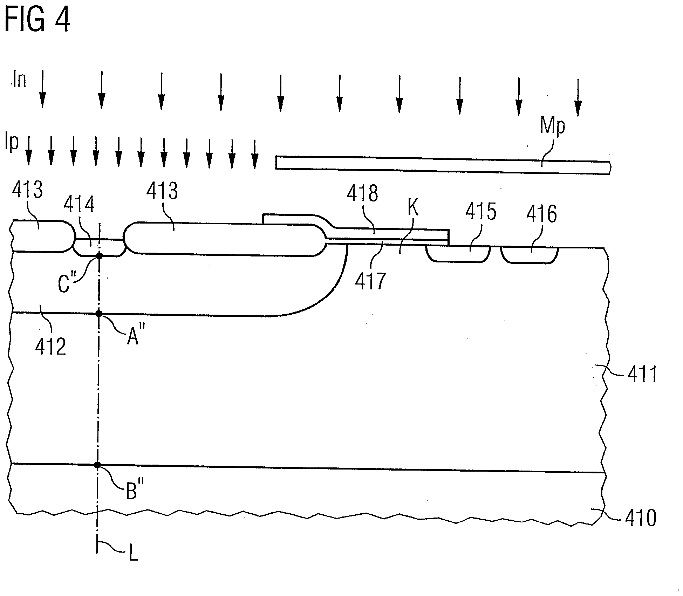

Die Erfindung wird insgesamt besser verständlich ausgehend von der Figur 4, die eine Weiterbildung des eingangs genannten Stands der Technik ist. Gemäß Figur 4 ist auf einem Substrat 410 eine dotierte n-leitende Wanne 411 angeordnet. Innerhalb der n-leitenden Wanne 411 ist ein hochdotierter p-leitfähiger Bereich 415 als Sourcegebiet vorgesehen. Daneben ist ein hochdotierter n-leitfähiger Bereich 416 angeordnet, der als Masseanschluss (Body) dienen kann. Auf der anderen Seite des Sourcegebiets 415 schließt sich der Kanal K an, über der, isoliert durch ein Gateoxid 417, die Gate-Elektrode 418 beispielsweise aus Polysilizium angeordnet ist.

In Richtung zum Draingebiet sind Feldoxidbereiche 413 vorgesehen, die ein Fenster zur Aufnahme des hochdotierten, p-leitfähigen Draingebiets 414 aufweisen. Unterhalb des Draingebiets 414 und der Feldoxidbereiche 413 ist eine dotierte p-leitende Wanne 412 innerhalb der n-leitenden Wanne 411 angeordnet, die sich lateral bis in den Kanal hinein erstreckt. Die Gate-Elektrode 418 ist in Richtung zum Draingebiet 414 bis über einen Bereich des Feldoxidbereichs 413 verlängert. Dieser oberhalb der p-leitenden Wanne liegende Bereich dient als Feldplatte zur Steuerung des elektrischen Feldes. Der Bereich der p-leitenden Wanne zwischen dem Draingebiet 414 und dem Kanal K dient als Driftbereich für die Ladungsträger und in lateraler Richtung zum Abbau des elektrischen Feldes. In Figur 4 ist der Hochvolt-PMOS-Transistor symmetrisch zur Linie L. In vertikaler Richtung unterhalb des Draingebiets 414 sind entlang der als Symmetrielinie für den PMOS-Transistor dienenden strichpunktierten Line L Punkte A", B" und C" eingezeichnet. Bei dem am Draingebiet anliegenden hohen Potenzial muss der Abstand A"-B" so bemessen sein, dass kein Punch zwischen der p-leitenden Wanne 412 und dem Substrat 410 erfolgen kann. Gleichzeitig muss der Abstand A"-C" so bemessen sein, dass die am Punkt A" auftretende kritische Feldstärke reduziert ist, wenn das Draingebiet 414 von hohem Potenzial auf niedriges Potenzial (Substratpotenzial) wechselt.

In Figur 4 ist weiterhin die Herstellung der n-leitenden Wanne und der p-leitenden Wanne während der Herstellung des Transistors schematisch dargestellt. In einem ersten Schritt wird dabei in dem Substrat 410 eine großflächige Implantation mit n-Ionen durchgeführt, für die im Bereich des beschriebenen Transistors keine Maske vorgesehen ist. Dies wird durch die gleichmäßig verteilten Pfeile und das Bezugszeichen In angedeutet.

In einem nachfolgenden Schritt wird dann die p-leitende Wanne 412 hergestellt. Dazu wird mit einer Maske Mp der Bereich der n-leitenden Wanne 411 abgedeckt, der den Kanal und das Sourcegebiet aufnehmen soll. Mittels einer durch gleichmäßige Pfeile in dem Fenster der Maske Mp durchgeführten Implantation Ip mit p-Ionen, beispielsweise Borionen, wird zunächst ein Implantationsgebiet erzeugt. In nachfolgenden thermischen Schritten, z.B. bei der Erzeugung der Feldoxide, diffundieren die p-Ionen aus, so dass die p-leitende Wanne 412 entsteht. Gegenüber der bezeichneten US 6,455,893 ergibt sich der Vorteil, dass unterhalb des Kanals und des Feldoxidbereichs eine Wannenstruktur entsteht, wie sie in der Figur 4 dargestellt ist. In den Randbereichen unter diesen Gebieten ergibt sich eine gleichmäßiger Dotierungsverlauf und damit eine bessere Feldsteuerung.

Im Beispiel der Figur 4 ist der pn-Übergang zwischen dem p-leitenden Substrat 410 und der n-leitenden Wanne 411 nahezu flach. Ebenfalls ist der pn-Übergang zwischen der p-leitenden Wanne 412 und der n-leitenden Wanne 411 unterhalb des Draingebiets 414 sehr flach. Der Abstand A"-C" wird durch den Diffusionsschritt nach der Implantation eingestellt. Dieser Abstand ist notwendig, da die Raumladungszone im Bereich des Punktes A" sich nicht bis zum p⁺-Diffusionsgebiet des Draingebiets 414 erstrecken darf. Gleichzeitig ist ein vorgegebener Abstand A"-B" gegeben, um einen Punch zwischen dem Substrat und der p-leitenden Wanne 412 zu verhindern.

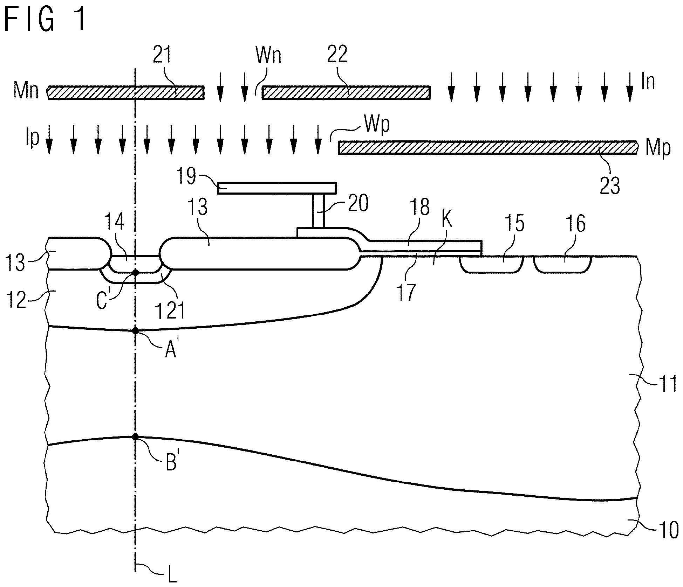

Figur 1 beschreibt Wannenformen, die gegenüber Figur 4 weiter verbessert sind. Gemäß Figur 1 ist in einem Substrat 10 eine dotierte n-leitende Wanne 11 angeordnet, die an ihrer Oberfläche eine hochdotierte p-leitfähige Zone 15 als Sourcegebiet enthält. Neben dem Sourcegebiet 15 ist ein hochdotierter, n-leitfähiger Bereich 16 vorgesehen, über den der Masseanschluss (Body) erfolgen kann.
Von dem Sourcegebiet 15 in Richtung zum hochdotierten, p-leitfähigen Draingebiet 14 schließt sich zunächst der Kanal K sowie eine dotierte p-leitende Wanne 12 an. Die p-leitende Wanne 12 erstreckt sich unterhalb des Draingebiets 14 in die Tiefe und lateral unterhalb der Feldoxidbereiche 13. Im Ausführungsbeispiel sind die Randbereiche der p-leitenden Wanne 12 bis unter die Gate-Elektrode 18 gezogen, die mittels des Gate-Oxids 17 von den beiden Wannen 11 und 12 sowie dem Sourcegebiet 15 isoliert ist.
Die Gate-Elektrode 18 ist z.B. als Polysiliziumschicht ausgebildet und erstreckt sich vom Gate bis auf den Feldoxidbereich 13 in Richtung Draingebiet 14. Soweit diese hochleitfähige verlängerte Gate-Elektrode oberhalb der p-leitenden Wanne 12 angeordnet ist, dient sie als Feldplatte zur Steuerung des elektrischen Feldes im Randbereich der p-leitenden Wanne 12. In einer höheren Ebene, im Ausführungsbeispiel der Metall-1-Ebene, ist oberhalb der Polysilizium-Feldplatte eine Metallschicht 19 vorgesehen, die sich oberhalb des Feldoxids zwischen Gate und Draingebiet weiter in Richtung Draingebiet 14 erstreckt. Elektrisch verbunden ist die Metallschicht 19 mit der Gate-Elektrode 18 mittels einer Durchkontaktierung 20.

In Figur 1 ist unterhalb des Draingebiets eine dotierte flache p-leitende Wanne 121 dargestellt, die an sich nicht notwendig, jedoch vorteilhaft bei Transistoren für besonders hohe Spannungen erzeugt wird. Die flache p-leitende Wanne 121 wird typischerweise als retrograde Wanne mit Bor und einer Energie von unter 150 keV sowie einer Konzentration von etwa 10¹³ cm⁻³ ausgeführt. Es wird ein kurzer Eintreibschritt ausgeführt. Der Bereich der flachen p-leitenden Wanne endet 0,5 µm unter der Siliziumoberfläche. Diese Wanne bewirkt eine Konzentration in ihrem Wannengebiet, die niedriger als die Draindotierung und höher als die Dotierung der p-leitenden Wanne 12 ist. Die Dotierung nimmt deshalb von dem Draingebiet in Richtung des Substrats gleichmäßiger ab, wodurch Überhöhungen der elektrischen Feldstärke oder ein Durchbruch vermieden werden.
Gemäß der Erfindung ist nun vorgesehen, dass sich der Wannenboden der p-leitenden Wanne 12 unterhalb des Draingebiets 14 tiefer in die n-leitende Wanne 11 hinein erstreckt als unterhalb des Feldoxidbereichs 13 und der Gate-Elektrode 18. Gleichzeitig erstreckt sich der Wannenboden der n-leitenden Wanne 11 unterhalb des Draingebiets 14 mit geringerer Tiefe in das Substrat 10 als in den übrigen Bereichen der Wanne. Die unterschiedlich tiefe Ausdiffusion der p-leitenden Wanne 12 wird gesteuert durch die Ausdiffusion der n-leitenden Wanne 11. So hat die n-leitende Wanne 11 im Bereich unterhalb des Draingebiets 14 eine niedrigere Konzentration als beispielsweise unterhalb des Sourcegebiets. Die Konzentrationsdifferenzen in der n-leitenden Wanne in lateraler Richtung ermöglichen es, dass die p-leitende Wanne 12 unterschiedlich stark ausdiffundieren kann. Insoweit wird die Ausdiffusion der p-leitenden Wanne durch die Diffusion der n-leitenden Wanne gesteuert. Aus diesem Grund erstreckt sich die p-leitende Wanne in der Tiefe unterhalb des Draingebiets weiter in die n-leitende Wanne hinein als in der Nähe des Kanals, weil in Kanalnähe die n-leitende Wanne 11 eine höhere Gegendotierung hat.

Die Formgebung der p-leitenden Wanne 12, die als Driftregion für die Ladungsträger auf dem weg zum Draingebiet 14 dient, bewirkt gegenüber einer Wanne mit flachem Boden einen größeren Abstand A'-C', d.h. in der Tiefe unterhalb des Draingebiets, und verhindert damit einen vorzeitigen Durchbruch. In lateraler Richtung zum Kanal hin wird die hohe Feldstärke des Draingebiets 14 durch die Wirkung der Feldplatten aus verlängerter Gate-Elektrode 18 und Metallschicht 19 verringert. Die Metallschicht 19 gehört
dabei zum standardmäßig für eine integrierte Schaltung verwendeten ersten Metallisierungsebene. Ebenfalls auch mit an sich bekannten Prozessschritten hergestellt wird die Durchkontaktierung 20 zwischen der Metallschicht 19 und der Polysilizium-Gate-Elektrode 18. Die Einbeziehung der Metallschicht 19 in die Feldplattenfunktion ermöglicht es, die Metallschicht 19 weiter von der Gate-Elektrode 18 in Richtung auf das Draingebiet 14 hinzuziehen, als es die verlängerte Gate-Elektrode 18 allein erlauben würde. Ursache hierfür ist die größere Entfernung zwischen der p-leitenden Wanne 12 und der Metallschicht 19 in diesem Bereich. Auf diese Weise ergibt sich eine reduzierte Oberflächenfeldstärke (RESURF-REduced SURface Field).

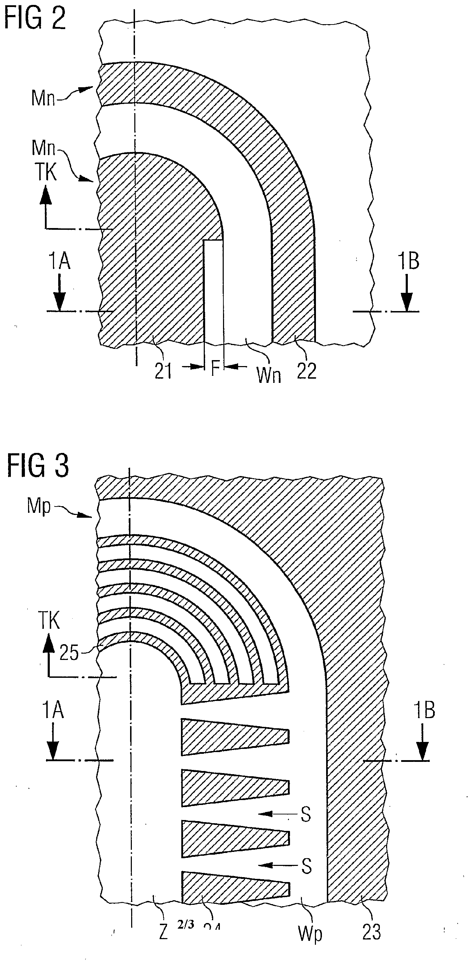

Die reduzierte Dotierungskonzentration in der Driftregion der p-leitenden Wanne 12 wird zusätzlich gesteuert durch die für die p-Implantation verwendete Maske, die nachfolgend anhand der Figur 3 beschrieben wird.

Es hat sich gezeigt, dass bei einem Hochvolt-PMOS-Transistor gemäß Figur 1 einerseits die Spannungsfestigkeit aufgrund der großen Entfernung zwischen den Punkten A' und C' erhöht wird und andererseits die Entfernung A'-B' ausreichend groß ist, um einen Punch von der p-leitenden Wanne 12 zum Substrat 10 zu verhindern.

Nachfolgend wird die Herstellung der Wannen 11 und 12 mit einer entsprechenden Maske bzw. Maskierung erläutert. Die Herstellung der Maske bzw. Maskierung erfolgt mit den in der Halbleitertechnik üblicherweise verwendeten Materialien und Verfahren. Für eine Transistorstruktur gemäß Figur 1 werden auf dem Halbleitersubstrat zunächst die n-leitende Wanne 11 und danach die p-leitende Wanne 12 erzeugt, bevor die Feldoxidbereiche 13 und die weiteren hochdotierten Bereiche für das Sourcegebiet und Gate bzw. Body hergestellt werden.

Als ersten Schritt wird auf dem undotierten Wafer eine Maske Mn hergestellt, die grundsätzlich oberhalb der Transistorstruktur der Figur 1 skizziert ist. Dabei wird die Maske so aufgebracht, dass Maskenteile 21 und 22 entstehen, durch die keine Ionenimplantation möglich ist. Anschließend werden durch das Fenster Wn sowie die außerhalb des Maskenteils 22 liegenden Bereiche eine Ionenimplantation In durchgeführt, bei der Phosphor-Ionen mit einer Energie von 300 keV und einer Dosis von bevorzugt 8,3 x 10¹² cm⁻² implantiert werden. Bevorzugt werden Phosphorionen implantiert, die während der thermischen Ausdiffusion beweglicher als beispielsweise Arsenionen sind, so dass sich mit Ausnahme der durch die Maskenteile 21, 22 abgeschatteten Bereiche eine relative gleichmäßige Verteilung der Phosphordotierung in der n-leitenden Wanne 11 ergibt.

Die dabei verwendete Maske ist prinzipiell anhand von Figur 2 dargestellt. Der Maskenteil 21 deckt den Zentralbereich des Draingebiets ab. Im Abstand von der Drainabdeckung durch das Maskenteil 21 ist eine weitere Abdeckung durch das Maskenteil 22 vorgesehen, die zwischen den für das Draingebiet und für das Sourcegebiet vorgesehenen Bereichen liegt. Im Ausführungsbeispiel der Figur 2 ist diese weitere Abdeckung streifenförmig ausgebildet. Die in Figur 1 skizzierte Maske Mn stellt sich als Querschnitt durch die Maske der Figur 2 entlang der Linie 1A und 1B dar.

Der Außenbereich des Transistors, der in der Figur 2 als Transistorkopf TK gekennzeichnet ist und in Figur 1 in Richtung senkrecht zur Zeichenebene liegt, wird dabei so gestaltet, dass zunächst der die Drainabdeckung bildende Maskenteil 21 um den doppelten Abstand F verbreitert wird und die Drainabdeckung dann halbkreisförmig zum Transistorkopf hin endet. In entsprechender Weise ist der durch das Maskenteil 22 gebildete streifenförmige Bereich zwischen Drain- und Sourcegebiet im Abstand zur Drainabdeckung ebenfalls als Kreisabschnitt angelegt. Selbstverständlich ist keine Kreisform der Drainabdeckung und der weiteren Abdeckung durch das Maskenteil 22 im Bereich des Transistorkopfes notwendig. Genauso können abschnittweise gradlinig verlaufende Polygonabschnitte aneinander gesetzt werden, um den Maskenabschluss des Transistorkopfes zu bilden.

Im Anschluss an die n-leitende Wanne 11 wird die p-leitende Wanne 12 mit einer weiteren Maske Mp implantiert. Figur 1 zeigt ebenfalls den Schnitt an der Stelle 1A-1B. Außerhalb des für die p-leitende Wanne 12 vorgesehenen Bereichs ist ein ganzflächiges Maskenteil 23 vorgesehen. In dem für die p-leitende Wanne vorgesehenen Bereich ist zunächst ein Fenster Wp erzeugt, in dem nebeneinander liegende, konisch in Richtung auf das Draingebiet zulaufende und voneinander beabstandete Abdeckungsbereiche bildende Maskenteile 24 vorgesehen sind. Die Schmalseite der konischen Abdeckungen beginnt im Abstand von dem Maskenteil 23 und verläuft dann in Richtung auf das Draingebiet bzw. den Zentralbereich Z des Transistors konisch zunehmend. Dabei bleiben zwischen den konischen Abdeckungen Bereiche frei, durch die eine Implantierung erfolgen kann. Der Zentralbereich Z der vorgesehenen p-leitenden Wanne bleibt abdeckungsfrei.

Die Maske Mp gemäß Figur 3 reduziert durch die Maskenteile 24 und 25 die effektive Implantierungsfläche mit Hilfe dieser konischen oder zylindrischen Maskierungsstreifen, damit die Dosis der p-Implantation im Bereich des Draingebiets kleiner wird. Dies ist notwendig, da im Bereich des Draingebiets eine geringere Dotierung der n-leitenden Wanne und damit eine geringere Gegendotierung der n-leitenden Wanne vorhanden ist.

Im Bereich des Transistorkopfes TK an dem endseitigen Bereich des Transistors sind mehrere bogenförmig und im Abstand zueinander verlaufende Abdeckungsstreifen als Maskenteile 25 angeordnet, die im Ausführungsbeispiel der Figur 3 nahezu parallel verlaufen.

Durch die freigelassenen Bereiche Wp, die von der Maskierung nicht bedeckt sind, erfolgt anschließend eine Implantation Ip mit p-Ionen, beispielsweise Borionen. Diese Implantation erfolgt in zwei Schritten, einmal mit beispielsweise einer Energie vom 300 keV und einer Dosis von 5 x 10¹² cm⁻² und im zweiten Schritt mit einer Energie von beispielsweise 150 keV und einer Dosis von ebenfalls 5 x 10¹² cm⁻². Selbstverständlich kann sowohl die Energie als auch die Dosis je nach dem Typ des verwendeten Herstellungsprozesses verändert werden. Die angegebenen Dosen beziehen sich dabei auf einen Prozess in einer Technologie mit der Strukturbreite 0,35 µm.

Mit der Implantation mit z.B. Bor ist die effektive p-Dotierung nahe dem Draingebiet am geringsten, da die konischen Maskenteile 24 sich fast berühren und so in diesem Bereich wenige p-Ionen ins Silizium eindringen. Entscheidend für die Potenzialverteilung ist jedoch die Nettodotierung. Da die n-leitende Wanne ebenfalls im Draingebiet eine geringere Dotierung hat, wird die Abnahme der p-Dotierung durch die Maskenteile 24 gegenkompensiert. Direkt unter dem Draingebiet ist die p-leitende Wanne am tiefsten. Der pn-Übergang wandert von dort in Richtung Sourcegebiet hin zur Oberfläche.

Die Maskierung der Figur 3 für die p-leitende Wanne 12 bewirkt, dass sich im Bereich zwischen Sourcegebiet und Draingebiet ein weitgehend homogener Potentialabfall bildet. Zwischen Sourcegebiet und Draingebiet wird dabei unterschiedlich ausgeprägter Driftdotierungskanal erzeugt, in dem der Stromfluss vom Sourcegebiet zum Draingebiet der durch die Pfeile S angedeuteten Richtung folgt.

Im Anschluss an die Implantationen für n-leitende Wanne und p-leitende Wanne erfolgen Temperaturschritte, die gewährleisten, dass sich eine Verteilung der Dotierstoffatome innerhalb der jeweiligen Wanne so ergibt, dass sie die gewünschte Funktion bewirken. Dies kann durch spezielle Diffusionsschritte erfolgen, auch im Zusammenhang beispielsweise mit der Herstellung der Feldoxidbereiche 13. Insgesamt bewirken die Maskierungsschritte und die Implantierung der p-leitenden Wanne 12, dass sich sowohl in vertikaler als auch in lateraler Richtung das elektrische Feld so einstellen lässt, dass keine Feldstärkeüberhöhung auftritt, die zu einem Durchbruch führen könnte. Damit lassen sich bei einem Niedervoltprozess, der an sich für Spannungen bis 5 Volt gedacht ist, Hochvolt-PMOS-Transistoren der erfindungsgemäßen Art erzeugen, die mit Betriebsspannungen von 50 Volt und darüber hinaus betrieben werden können.

## Patentansprüche

1. Hochvolt-PMOS-Transistor
mit einer isolierten Gate-Elektrode (18),
mit einem p-leitenden Sourcegebiet (15) in einer n-leitenden Wanne (11), die in einem p-leitenden Substrat (10) angeordnet ist,
mit einem p-leitenden Draingebiet (14) in einer p-leitenden Wanne (12), die in der n-Wanne angeordnet ist, mit einem sich an das Sourcegebiet (15) in Richtung zum Draingebiet (14) anschließenden Kanal (K) und
mit einem Feldoxidbereich (13) zwischen Gate-Elektrode und Draingebiet,
wobei die im Substrat (10) bezüglich einer oberen Substratoberfläche gemessene Tiefe der n-leitenden Wanne unterhalb des Draingebiets (14) geringer ist als unterhalb des Sourcegebiets (15) und die im Substrat (10) bezüglich der oberen Substratoberfläche gemessene Tiefe der p-leitenden Wanne unterhalb des Draingebiets (14) am größten ist.

2. Hochvolt-PMOS-Transistor nach Anspruch 1, **dadurch gekennzeichnet, dass** sich die p-leitende Wanne (12) lateral von dem Draingebiet (14) bis zur Gate-Elektrode (18) erstreckt.

3. Hochvolt-PMOS-Transistor nach Anspruch 1 oder 2, **dadurch gekennzeichnet, dass** die Gate-Elektrode (18) sich oberhalb einer Isolierschicht (17) von dem Sourcegebiet (15) bis auf den Feldoxidbereich (13) in Richtung Draingebiet (14) erstreckt, sodass sie die Randbereiche der p-leitenden Wanne (12) überdeckt.

4. Hochvolt-PMOS-Transistor nach einem der Ansprüche 1 bis 3, **dadurch gekennzeichnet, dass** eine Metallschicht (19) in einem Abstand oberhalb des Feldoxidbereich (13) verläuft und mittels einer Durchkontaktierung (20) mit der Gate-Elektrode (18) verbunden ist und dass sich die Metallschicht von der Gate-Elektrode in Richtung zum Draingebiet (14) über dem Isolationsbereich erstreckt.

5. Hochvolt-PMOS-Transistor nach einem der Ansprüche 1 bis 4, **dadurch gekennzeichnet, dass** die p-leitende Wanne (12) im Bereich des Draingebiets (14) höher dotiert ist als in einem Außenbereich zum Kanal (K) hin.

6. Hochvolt-PMOS-Transistor nach einem der Ansprüche 1 bis 5, **dadurch gekennzeichnet, dass** die n-leitende Wanne (11) unterhalb des Draingebiets (14) niedriger dotiert ist als im Bereich unterhalb des Kanals (K).

7. Verfahren zur Herstellung einer n-leitenden Wanne (11) und einer p-leitenden Wanne (12) eines Hochvolt-PMOS-Transistors mit einer isolierten Gate-Elektrode (18), mit einem p-leitenden Sourcegebiet (15) in einer in einem p-leitenden Substrat (10) angeordneten n-leitenden Wanne (11), mit einem p-leitenden Draingebiet (14) in einer in der n-Wanne angeordneten p-leitenden Wanne (12), mit einem sich an das Sourcegebiet (15) in Richtung zum Draingebiet (14) anschließenden Kanal (K) und mit einem Feldoxidbereich (13) zwischen Gate-Elektrode und Draingebiet, bei dem
eine Implantation von Ionen mittels Masken so erfolgt, dass die im Substrat (10) bezüglich einer oberen Substratoberfläche gemessene Tiefe der n-leitenden Wanne unterhalb eines für das Draingebiet (14) vorgesehenen Bereiches geringer ist als unterhalb eines für das Sourcegebiet (15) vorgesehenen Bereiches und die im Substrat (10) bezüglich der oberen Substratoberfläche gemessene Tiefe der p-leitenden Wanne unterhalb eines für das Draingebiet (14) vorgesehenen Bereiches am größten ist.

8. Verfahren nach Anspruch 7, bei dem zur Herstellung der n-leitenden Wanne (11) eine Maske (Mn) verwendet wird, mit der der für das Draingebiet (14) vorgesehene Bereich mit einer Drainabdeckung (21) abgedeckt wird und im Abstand von der Drainabdeckung (21) eine weitere Abdeckung (22) zwischen den für das Draingebiet (14) und das Sourcegebiet (15) vorgesehenen Bereichen gebildet wird.

9. Verfahren nach Anspruch 8, **dadurch gekennzeichnet, dass** die weitere Abdeckung (22) streifenförmig ausgebildet ist.

10. Verfahren nach Anspruch 8 oder 9, **dadurch gekennzeichnet, dass** die Drainabdeckung (21) im Bereich eines Transistorkopfes (TK), der einen Außenbereich des Transistors bildet, zunächst verbreitert ist und sich dann verjüngt.

11. Verfahren nach einem der Ansprüche 8 bis 10, **dadurch gekennzeichnet, dass** die Drainabdeckung (21) im Bereich des Transistorkopfes (TK) im Bogen verläuft.

12. Verfahren nach einem der Ansprüche 8 bis 11, **dadurch gekennzeichnet, dass** die weitere Abdeckung (22) im Bereich des Transistorkopfes mit Abstand dem Verlauf der Drainabdeckung folgt.

13. Verfahren nach einem der Ansprüche 7 bis 12, bei dem zur Herstellung der p-leitenden Wanne (12) eine weitere Maske (Mp) verwendet wird, mit der zwischen dem für das Draingebiet (14) vorgesehenen Bereich und einem Randbereich der zu erzeugenden Wanne abschnittweise weitere Abdeckungen (24, 25) vorgesehen sind, wobei die weiteren Abdeckungen (24, 25) konisch verlaufende Streifen (24) enthalten, die sich vom Sourcegebiet (15) zum Draingebiet (14) hin verbreitern und voneinander beabstandet sind.

14. Verfahren nach Anspruch 13, **dadurch gekennzeichnet, dass** die weiteren Abdeckungen (25) im Bereich des Transistorkopfes als voneinander beabstandete Streifen ausgebildet sind.

15. Verfahren nach Anspruch 14, **dadurch gekennzeichnet, dass** die beabstandeten Streifen der weiteren Abdeckungen (25) im Bereich des Transistorkopfes mehrere im Bogen verlaufende Streifen sind.

16. Verfahren nach Anspruch 13 oder 15, **dadurch gekennzeichnet, dass** die Streifen zumindest abschnittweise parallel verlaufen.

## Claims

1. A high-voltage PMOS transistor
having an isolated gate electrode (18),
having a p-conducting source region (15) in an n-conducting well (11), which is arranged in a p-conducting substrate (10),
having a p-conducting drain region (14) in a p-conducting well (12), which is arranged in the n well, having a channel (K) adjoining the source region (15) in the direction toward the drain region (14) and having a field oxide area (13) between the gate electrode and the drain region,
wherein the depth of the n-conducting well, as measured in the substrate (10) with respect to an upper substrate surface, below the drain region (14) is less than below the source region (15), and the depth of the p-conducting well, as measured in the substrate (10) with respect to the upper substrate surface, is greatest below the drain region (14).

2. The high-voltage PMOS transistor according to claim 1, **characterized in that** the p-conducting well (12) extends laterally from the drain region (14) to the gate electrode (18) .

3. The high-voltage PMOS transistor according to claim 1 or 2, **characterized in that** the gate electrode (18) extends above an isolating layer (17) from the source region (15) up to the field oxide area (13) in the direction toward the drain region (14) such that it covers the edge areas of the p-conducting well (12).

4. The high-voltage PMOS transistor according to one of claims 1 to 3, **characterized in that** a metal layer (19) passes at a distance above the field oxide area (13) and is connected to the gate electrode (18) by means of a through-hole plating (20), and that the metal layer extends from the gate electrode in the direction toward the drain region (14) above the isolation area.

5. The high-voltage PMOS transistor according to one of claims 1 to 4, **characterized in that** the p-conducting well (12) is doped higher in the area of the drain region (14) than in an outer area toward the channel (K).

6. The high-voltage PMOS transistor according to one of claims 1 to 5, **characterized in that** the n-conducting well (11) below the drain region (14) is doped less than in the area below the channel (K).

7. A method for producing an n-conducting well (11) and a p-conducting well (12) of a high-voltage PMOS transistor having an isolated gate electrode (18), having a p-conducting source region (15) in an n-conducting well (11) arranged in a p-conducting substrate (10), having a p-conducting drain region (14) in a p-conducting well (12) arranged in the n well, having a channel (K) adjoining the source region (15) in the direction toward the drain region (14) and having a field oxide area (13) between the gate electrode and the drain region, in which
an implantation of ions by means of masks is performed such that the depth of the n-conducting well, as measured in the substrate (10) with respect to an upper substrate surface, below an area provided for the drain region (14) is less than below an area provided for the source region (15), and the depth of the p-conducting well, as measured in the substrate (10) with respect to the upper substrate surface, is greatest below an area provided for the drain region (14).

8. The method according to claim 7, in which, for producing the n-conducting well (11), a mask (Mn) is used, by means of which the area provided for the drain region (14) is covered with a drain cover (21), and at a distance from the drain cover (21), a further cover (22) is formed between the areas provided for the drain region (14) and the source region (15) .

9. The method according to claim 8, **characterized in that** the further cover (22) is formed in a strip shape.

10. The method according to claim 8 or 9, **characterized in that** the drain cover (21), in the area of a transistor head (TK), which forms an outer area of the transistor, at first is widened and then tapered.

11. The method according to one of claims 8 to 10, **characterized in that** the drain cover (21) traces an arc in the area of the transistor head (TK).

12. The method according to one of claims 8 to 11, **characterized in that** the further cover (22) follows the course of the drain cover at a distance in the area of the transistor head.

13. The method according to one of claims 7 to 12, in which, for producing a p-conducting well (12), a further mask (Mp) is used, by which further covers (24, 25) are provided in sections between the area provided for the drain region (14) and an edge area of the well to be produced, wherein the further covers (24, 25) contain conically extending strips (24), which are widened from the source region (15) to the drain region (14) and are spaced from one another.

14. The method according to claim 13, **characterized in that** the further covers (25) are formed as strips spaced from one another in the area of the transistor head.

15. The method according to claim 14, **characterized in that** the spaced strips of the further covers (25) are a plurality of strips tracing an arc in the area of the transistor head.

16. The method according to claim 13 or 15, **characterized in that** the strips extend in parallel at least in sections.

## Revendications

1. Transistor PMOS haute tension
comprenant une électrode de grille (18) isolée,
comprenant une zone de source (15) à conductivité de type p dans un puits (11) à conductivité de type n, qui est disposé dans un substrat (10) à conductivité de type p,
comprenant une zone de drain (14) à conductivité de type p dans un puits (12) à conductivité de type p, qui est disposé dans le puits de type n, comprenant un canal (K) rejoignant la zone de source (15) en direction de la zone de drain (14) et une région d'oxyde de champ (13) entre l'électrode de grille et la zone de drain,
sachant que la profondeur du puits à conductivité de type n mesurée dans le substrat (10) par rapport à une surface supérieure de substrat est plus petite sous la zone de drain (14) que sous la zone de source (15), et la profondeur du puits à conductivité de type p mesurée dans le substrat (10) par rapport à la surface supérieure de substrat est la plus grande sous la zone de drain (14).

2. Transistor PMOS haute tension selon la revendication 1, **caractérisé en ce que** le puits (12) à conductivité de type p s'étend latéralement depuis la zone de drain (14) jusqu'à l'électrode de grille (18).

3. Transistor PMOS haute tension selon la revendication 1 ou 2, **caractérisé en ce que** l'électrode de grille (18) s'étend au-dessus d'une couche isolante (17) depuis la zone de source (15) jusqu'à la région d'oxyde de champ (13) en direction de la zone de drain (14) de telle sorte qu'elle recouvre les zones marginales du puits (12) à conductivité de type p.

4. Transistor PMOS haute tension selon l'une des revendications 1 à 3, **caractérisé en ce qu'**une couche de métal (19) se situe à une distance au-dessus de la région d'oxyde de champ (13) et est reliée moyennant une interconnexion (20) à l'électrode de grille (18) et **en ce que** la couche de métal s'étend depuis l'électrode de grille vers la zone de drain (14) au-dessus de la zone d'isolation.

5. Transistor PMOS haute tension selon l'une des revendications 1 à 4, **caractérisé en ce que** le puits à conductivité de type p (12) est plus fortement dopée au niveau de la zone de drain (14) que dans une région extérieure vers le canal (K).

6. Transistor PMOS haute tension selon l'une des revendications 1 à 5, **caractérisé en ce que** le puits (11) à conductivité de type n est moins fortement dopée sous la zone de drain (14) que dans la région sous le canal (K).

7. Procédé de fabrication d'un puits à conductivité de type n (11) et d'un puits (12) à conductivité de type p d'un transistor PMOS haute tension comprenant une électrode de grille (18) isolée, une zone de source (15) à conductivité de type p dans un puits (11) à conductivité de type n disposé dans un substrat (10) à conductivité de type p, une zone de drain (14) à conductivité de type p dans un puits (12) à conductivité de type p disposé dans le puits de type n, un canal (K) rejoignant la zone de source (15) en direction de la zone de drain (14) et une région d'oxyde de champ (13) entre l'électrode de grille et la zone de drain,
dans lequel une implantation d'ions est effectuée au moyen de masques de telle façon que la profondeur du puits à conductivité de type n mesurée dans le substrat (10) par rapport à une surface supérieure de substrat soit plus petite sous une région prévue pour la zone de drain (14) que sous une région prévue pour la zone de source (15), et la profondeur du puits à conductivité de type p mesurée dans le substrat (10) par rapport à la surface supérieure de substrat soit la plus grande sous une région prévue pour la zone de drain (14).

8. Procédé selon la revendication 7, dans lequel, pour la fabrication du puits (11) à conductivité de type n, un masque (Mn) avec lequel la région prévue pour la zone de drain (14) est recouverte d'un recouvrement de drain (21) est utilisé et un recouvrement (22) supplémentaire est formé à distance du recouvrement de drain (21) entre les régions prévues pour la zone de drain (14) et la zone de source (15).

9. Procédé selon la revendication 8, **caractérisé en ce que** le recouvrement (22) supplémentaire est constitué en forme de bandes.

10. Procédé selon la revendication 8 ou 9, **caractérisé en ce que** le recouvrement de drain (21), dans la région d'une tête de transistor (TK) qui forme une région extérieure du transistor, est d'abord élargi et s'amincit ensuite.

11. Procédé selon l'une des revendications 8 à 10, **caractérisé en ce que** le recouvrement de drain (21) présente un tracé courbe dans la région de la tête de transistor (TK).

12. Procédé selon l'une des revendications 8 à 11, **caractérisé en ce que** le recouvrement (22) supplémentaire suit à distance le tracé du recouvrement de drain dans la région de la tête de transistor.

13. Procédé selon l'une des revendications 7 à 12, sachant que, pour la fabrication du puits (12) à conductivité de type p, un masque (Mp) supplémentaire avec lequel des recouvrements (24, 25) supplémentaires sont prévus par portions entre la région prévue pour la zone de drain (14) et une région marginale du puits à réaliser est utilisé, sachant que les recouvrements (24, 25) supplémentaires contiennent des bandes (24) au tracé conique qui s'élargissent depuis la zone de source (15) vers la zone de drain (14) et sont espacées les unes des autres.

14. Procédé selon la revendication 13, **caractérisé en ce que** les recouvrements (25) supplémentaires sont constitués comme bandes espacées les unes des autres dans la région de la tête de transistor.

15. Procédé selon la revendication 14, **caractérisé en ce que** les bandes espacées des recouvrements (25) supplémentaires sont plusieurs bandes au tracé courbe dans la région de la tête de transistor.

16. Procédé selon la revendication 13 ou 15, **caractérisé en ce que** les bandes présentent, au moins par portions, un tracé parallèle.
